# EUROPÄISCHE PATENTANMELDUNG

(11) **EP 2 058 751 A2**
(43) Veröffentlichungstag der Anmeldung: **13.05.2009**
(21) Anmeldenummer: 08105339.9
(22) Anmeldetag: 15.09.2008
(51) Int. Cl.: G06K 9/20, G06K 9/00, B60Q 1/14

(54) **Kamera zur Erfassung eines Fahrzeugumfeldes**

(30) Priorität: 08.11.2007 DE 102007053307
(71) Anmelder: Robert Bosch GmbH, 70442 Stuttgart (DE)
(72) Erfinder: Haug, Karsten, 70372 Stuttgart (DE)

(57) **Zusammenfassung**

Die Erfindung betrifft eine Kamera zur winkelaufgelösten Erfassung eines Fahrzeugumfeldes (4), die einen Imager-Sensor (7), insbesondere in CMOS-oder CCD-Technolgie, aufweist, der mindestens eine sensitive Schicht (7a) mit mehreren Bildpixeln (Pij) zur winkelaufgelösten Aufnahme von sichtbarer optischer und/oder infraroter Strahlung (8, 8a, 8b) und zur Ausgabe eines Bildsignals (fi) aufweist.

Erfindungsgemäß ist vorgesehen, dass auf oder vor dem Imager-Sensor (7) eine nachleuchtende Einrichtung (7c) vorgesehen ist, die zumindest einen Teil der aufgenommenen Strahlung (8, 8a) mit einer zeitlichen Tiefpassfilterung zu der fotosensitiven Schicht (7a) weitergibt.

Vorteilhafterweise ist die Zeitkonstante (tk) der nachleuchtenden Einrichtung (7) der Ausleserate der Frames der Kamera (3) angepasst.

## Beschreibung

### Stand der Technik

Die Erfindung betrifft eine Kamera zur Erfassung eines Fahrzeugumfeldes. Derartige Kameras werden in Fahrzeugen eingesetzt, um Bilder des Fahrzeugumfeldes zu gewinnen und diese dem Fahrer auf einem Monitor anzuzeigen und/oder sie für ein Assistenzsystem einzusetzen, das dem Fahrer die Führung des Fahrzeuges erleichtert, z. B. durch einen Eingriff in die Führung des Fahrzeuges, insbesondere die Bremsen und/oder das Motormanagement oder durch eine Steuerung von Beleuchtungsfunktionen.

Derartige Fahrzeugkameras sind z.B. im Fahrzeuginnenraum hinter der Windschutzscheibe angebracht und erfassen als Fahrzeugumfeld insbesondere den Fahrbahnbereich vor dem Fahrzeug und gegebenenfalls Bereiche seitlich neben der Fahrbahn. Hierdurch können insbesondere sich auf der gleichen Fahrspur vor dem eigenen Fahrzeug oder einer benachbarten Fahrspur befindende andere Fahrzeuge und Objekte aufgenommen werden, um kritische Fahrsituationen zu erkennen und/oder die Beleuchtung des eigenen Fahrzeuges anzupassen, z.B. durch Umschalten zwischen Fern- und Abblendlicht.

Die Kamerasysteme ermöglichen unter anderem eine präzise Messung des Abstandes. Weiterhin werden sie in zunehmendem Umfang für Nachtsichtfunktion eingesetzt, bei der ein Infrarot-Fernscheinwerfer eine Szene vor dem Fahrzeug ausleuchtet und reflektierte Strahlung von der Kamera aufgenommen wird. Die Kamera kann hierbei sowohl im Infrarotbereich als auch im optischen Bereich sensitiv sein und somit die reflektierte Infrarotstrahlung und gegebenenfalls von Objekten ausgestrahlte optische und infrarote Strahlung zusammen aufnehmen und somit eine hohe Ausleuchtung bzw. Sensitivität erreichen.

Die Kameras weisen in der Regel einen Imager-Sensor bzw. Imager -Chip zur winkelaufgelösten Aufnahme eines Bildes und eine Optik bzw. ein optisches System auf, das einen Erfassungsbereich des Fahrzeugumfeldes auf dem Imager-Sensor abbildet. Als Imager-Sensoren werden im Allgemeinen CCD-Chips oder CMOS-Chips eingesetzt, die eine Matrixanordnung aus einzelnen Bildpixeln aufweisen, um ein winkelaufgelöstes Bild zu ermöglichen.

Da die Strahlung nur in bestimmten Zeitintervallen, z. B. der shutter time bei CCD-Kameras, ausgelesen wird, besteht grundsätzlich das Risiko, dass von der Kamera erfasste gepulste Lichtquellen verfälscht dargestellt werden. Die verfälschte Darstellung entsteht dadurch, dass die Einschaltphasen der gepulsten Lichtquellen nicht mit den Belichtungsphasen der Kamera übereinstimmen. Je nachdem, ob die Lichtquelle während der kurzen, starken Lichtimpulse oder in den dazwischen liegenden lichtfreien Zeiten aufgenommen wird, kann die Lichtquelle mit zu hoher Intensität, zu geringer Intensität oder gegebenenfalls auch gar nicht erfasst und wiedergeben werden. Dies kann insbesondere bei gepulsten Lichtquellen in LED-Technologie, die für Brems-und Heckleuchten vorausgehender Fahrzeuge eingesetzt werden, aber auch bei entgegenkommenden Fahrzeugen mit gepulster LED-Frontbeleuchtung auftreten.

Somit kann bei Darstellung auf einem Monitor, insbesondere auf einem Night-Vision-Display einer Nachtsichtfunktion ein vorausfahrendes oder entgegenkommendes Fahrzeug gar nicht oder nur schlecht erkannt werden. Dies ist auch für nicht-darstellende Funktionen kritisch, wie z. B. einen Fernlicht-Assistent oder ein Video-basiertes ACC (automatic cruise control).

Die DE 10 2005 033 863 A1 beschreibt ein Bildaufnahmesystem, bei dem zusätzlich zu der Kamera ein Strahlungssensor für die Erfassung der gepulsten Lichtquelle vorgesehen ist. Die Kamera und der Strahlungssensor werden von einer gemeinsamen Steuereinrichtung ausgelesen, die die Diskrepanz zwischen der Belichtungsphase der Kamera und der Einschaltphase der gepulsten Lichtquelle erfasst. Hierbei kann die Belichtungszeit und - phase des Imager-Sensors der Kamera verändert werden, um auf die gepulste Lichtquelle eingestellt zu werden.

Ein derartiges System ermöglicht grundsätzlich eine höhere Sicherheit bei der Detektion gepulster Lichtquellen. Es erfordert jedoch durch den zusätzlichen Strahlungssensor einen hohen apparativen Aufwand und/oder tiefere Eingriffe in die Belichtungsstrategie des Imagers, wozu eine komplexe algorithmische Strategie erforderlich ist. Hierbei ist zum Teil auch die schnelle Umschaltung des Imager-Sensors zwischen verschiedenen Belichtungsmodi nicht unproblematisch.

Die EP 0 438 889 A1 zeigt einen Sensor, der als Schichtfolge aus Siliziumschichen und Metallschichten ausgebildet ist. Er kann als Röntgendetektor verwendet werden, indem auf seiner Oberseite eine Röntgenstrahlen absorbierenden Schicht aufgetragen ist, die auch phosphoreszierend mit einer Nachleuchtwirkung sein kann.

### Offenbarung der Erfindung

Der Erfindung liegt der Gedanke zugrunde, in den Strahlengang vor dem Imager-Sensor eine zusätzliche Einrichtung mit einem für relevante Wellenlängen nachleuchtenden Effekt vorzusehen, die bei Eintreffen des äußeren Primärlichtes eine gewisse Zeitdauer nachleuchtet. Diese Einrichtung kann insbesondere eine auf die Oberfläche des Imager-Sensors aufgebrachte Schicht sein, so dass ein Bereich dieser Schicht vor jedem Bildpixel unabhängig von den anderen Bereichen der Schicht nachleuchtet.

Es wird somit eine optische zeitliche Tiefpassfilterung durchgeführt und ein zeitliches Anti-Aliasing-Filter optisch realisiert.

Durch die erfindungsgemäße Nachleuchtwirkung wird die zeitlich Tiefpass gefilterte Strahlung nachfolgend von der sensitiven Schicht bzw. dem eigentlichen Imager-Sensor erfasst, auch wenn die Belichtungsphasen und Auslesephasen des Imager-Sensors zeitlich voneinander getrennt sind.

Die Erfindung berücksichtigt hierbei im zeitlichen Verlauf das Abtasttheorem von Shannon, gemäß dem die Abtastfrequenz hinreichend groß sein soll, um ein Signal zu erfassen. Hierbei muss für eine vollständige Informationserfassung die Abtastfrequenz mindestens doppelt so hoch wie die höchste Signalfrequenz bzw. Bandbreite des Signals sein. Erfindungsgemäß wird hierbei die Bandbreite begrenzt, da die Kameraabtastfrequenz meist nicht verändert werden kann.

Somit wird auch die menschliche Anatomie des Auges bzw. der Sinneswahrnehmung nachgebildet, die bei hohen Bildfrequenzen größer 20 Hz eine durchgehende Beleuchtung suggeriert und die letztlich den Einsatz von gepulsten Lichtquellen im Straßenverkehr erst ermöglicht.

Erfindungsgemäß sind vorteilhafterweise einerseits die Zeitkonstante der Nachleuchtwirkung und andererseits die Auslesefrequenz der Bildframes bzw. Framerate und/oder die Pulsfrequenz der Beleuchtung so aufeinander abgestimmt bzw. angepasst, dass das Abtasttheorem von Shannon eingehalten wird.

So kann der Kehrwert der Zeitkonstante der Nachleuchtwirkung der Nachleuchtschicht im wesentlichen der halben Framerate des Imager-Sensors, mit der die Frames bzw. aus allen Bildpixeln gebildeten Bilder ausgelesen werden, entsprechen, so dass auch bei Auftreffen eines kurzen Lichtimpulses die Nachleuchtzeitdauer immer von einer Abtastung erfasst wird. Vorteilhafterweise ist die Nachleuchtdauer hierbei auch nicht deutlich länger als vom Abtastheorem gefordert, d.h. nicht deutlich länger als das Doppelte des Kehrwertes der Abtastfrequenz bzw. Framerate, um die Dynamik der Bilderfassung nicht zu verschlechtern und ein Verschmieren des Bildes, insbesondere der stärker belichteten Bildbereiche, zu vermeiden.

Bei üblichen Kameras liegt die Abtastrate z. B. bei 50 Hz oder auch weniger, die Pulsfrequenz der LEDs jedoch bei z. B. 50 bis 100 Hz. Somit werden erfindungsgemäß vorzugsweise Zeitkonstanten von über 40 msec entsprechend einer abzutastenden Signalfrequenz von 25 Hz gewählt, so dass das Abtasttheorem erfüllt wird.

Erfindungsgemäß wird somit bereits auf physikalischer Ebene eine Tiefpassfilterung des einfallenden Primärlichtes der bestimmten Wellenlängenbereiche vor Eintreffen des Lichts auf den Imager-Sensor erreicht. Die Tiefpasswirkung entspricht hierbei einem physikalischen Anti-Aliasing-Filter.

Die relevanten Wellenlängenbereiche liegen insbesondere im sichtbaren optischen und/oder im (nahen und fernen) infraroten Bereich d.h. z. B. zwischen 400 und 1000 nm, so dass auch Nachtsichteinrichtungen unterstützt werden können.

Wenn die Dämpfung des Filters durch Strahlungsabsorption vernachlässigt wird, entspricht die Kamerawahrnehmung erfindungsgemäß im wesentlichen dem menschlichen Auge, so dass die erfindungsgemäße Tiefpassfilterung keine qualitative Verschlechterung des wahrgenommenen Bildes erzeugt.

Für nicht gepulste sichtbare oder infrarote Strahlung erfolgt bei hinreichend kleiner Zeitkonstante keine oder allenfalls eine vernachlässigbare Verschlechterung des ausgelesenen Bildes bzw. keine oder eine allenfalls gering beeinträchtigte Dynamik. Gepulstes Licht wird durch die Tiefpassfilterung als nicht gepulstes oder auch als teilweise gepulstes Licht aufgenommen, das in den Belichtungsphasen eine etwas höhere und in den Zwischenphasen, in denen lediglich der Nachleuchteffekt relevant ist, eine niedrigere Intensität aufweisen kann. Für den Betrachter ergibt sich keine Änderung der Intensität.

Erfindungsgemäß wird somit durch relativ geringen zusätzlichen Aufwand, nämlich die zusätzliche Aufbringung einer Nachleuchtschicht mit entsprechender Tiefpasswirkung, eine deutlich erhöhte Sicherheit erreicht.

Gegebenenfalls kann vor der Nachleuchtschicht ergänzend eine halbspiegelnde Schicht vorgesehen sein, die ein Zurückstrahlen des Lichtes von der Nachleuchtschicht nach vorne verringert oder vermeidet. Alternativ oder ergänzend hierzu kann erfindungsgemäß auch eine Antireflexschicht auf der Vorderseite der Nachleuchtschicht vorgesehen sein, um eine Intensitätsminderung der einfallenden Strahlung zu vermeiden.

Die Nachleuchtschicht kann insbesondere eine phosphoreszierende Schicht sein, die z.B. bereits passiv das aufgenommene Primärlicht mit zeitlicher Verzögerung wieder abgibt.

Weiterhin sind auch aktive Nachleuchtschichten möglich, die bei Aufnahmen der einfallenden Primärstrahlung unter zusätzlichem Energieaufwand, z.B. durch Anlegen einer zusätzlichen elektrischen Spannung, ein Nachleuchten bewirken oder verstärken. Dies kann z. B. nach dem Prinzip der Restlichtverstärkung erfolgen. Eine aktive Nachleuchtschicht kann z. B. ausgebildet werden, indem einzelne Zellen jeweils als Photomultiplier und/oder Sekundärelektronenvervielfacher, z. B. mit einer Mikrokanalplatte (MCP) ausgebildet sind.

Weiterhin sind laterale Strukturierungen der Nachleuchtschicht möglich, um relevantere Bereiche des erfassten Fahrzeugumfeldes, z.B. den rechten Bereich mit zu erwartenden Rückleuchten vorausgehender Fahrzeuge, ganz oder stärker mit dem Nachleuchteffekt zu erfassen und andere Bereiche gar nicht oder weniger stark mit dem Nachleuchteffekt zu erfassen.

Erfindungsgemäß wird somit auch ein Fahrzeug ermöglicht, dessen Steuereinrichtung mit den Bildsignalen bzw. Framesignalen der Kamera eine bessere Ansteuerung von Assistenzfunktionen, z.B. auch der Umschaltfunktion zwischen Abblendlicht und Fernlicht, ermöglicht. Weiterhin werden auch andere Assistenzfunktionen wie z.B. Abstandsmessung zu vorausfahrenden Fahrzeugen sowie automatische Abstandsregelung, verbessert.

### Kurze Beschreibung der Zeichnungen

- Fig. 1: zeigt eine Straßenszene eines Fahrzeug mit einer Kamera zur Erfassung seines Fahrzeugumfeldes;
- Fig. 2: zeigt eine erfindungsgemäße Kamera;
- Fig. 2a: einen Ausschnitt aus Fig. 2;
- Fig. 3: zeigt eine Vorderansicht des Imager-Sensors gemäß einer Ausführungsform mit lateraler Strukturierung der Nachleuchtschicht;
- Fig. 4: ein Diagramm der von der Nachleuchtschicht an die fotosensitive Schicht abgegebenen Intensität in Abhängigkeit der Zeit.

### Ausführungsformen der Erfindung

In einem Fahrzeug 1 ist z.B. hinter dessen Windschutzscheibe 2 eine Kamera 3 angeordnet, die ein Fahrzeugumfeld 4 außerhalb des Fahrzeugs 1 erfasst. Das Fahrzeugumfeld 4 kann insbesondere den Fahrbahnbereich 5 vor und neben dem Fahrzeug 1, weiterhin z.B. auch Bereiche neben dem Fahrbahnbereich 5 mit Verkehrsschildern, Bäumen, Gebäuden usw. erfassen.

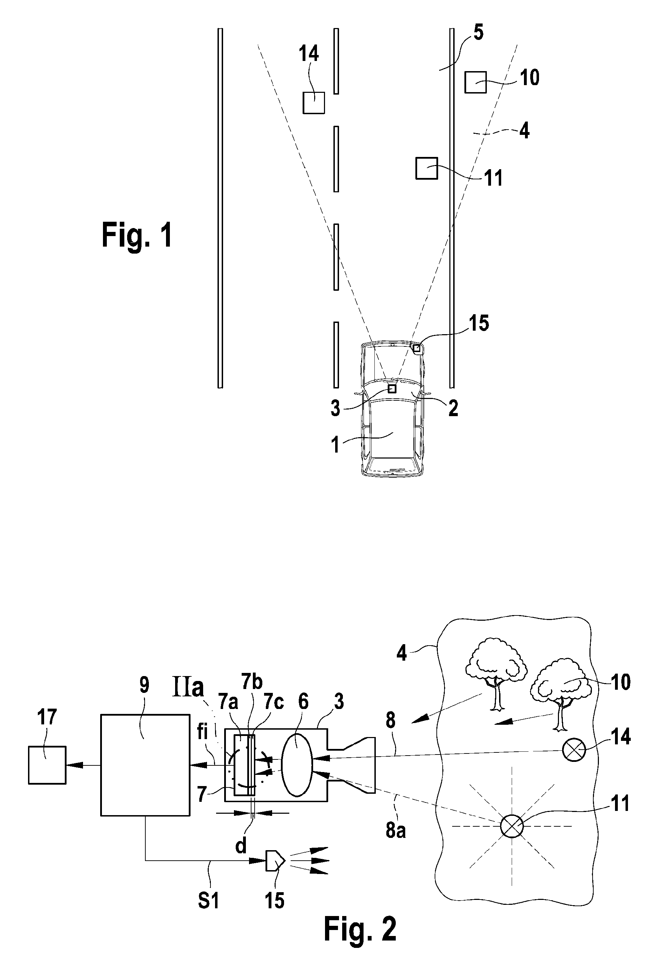

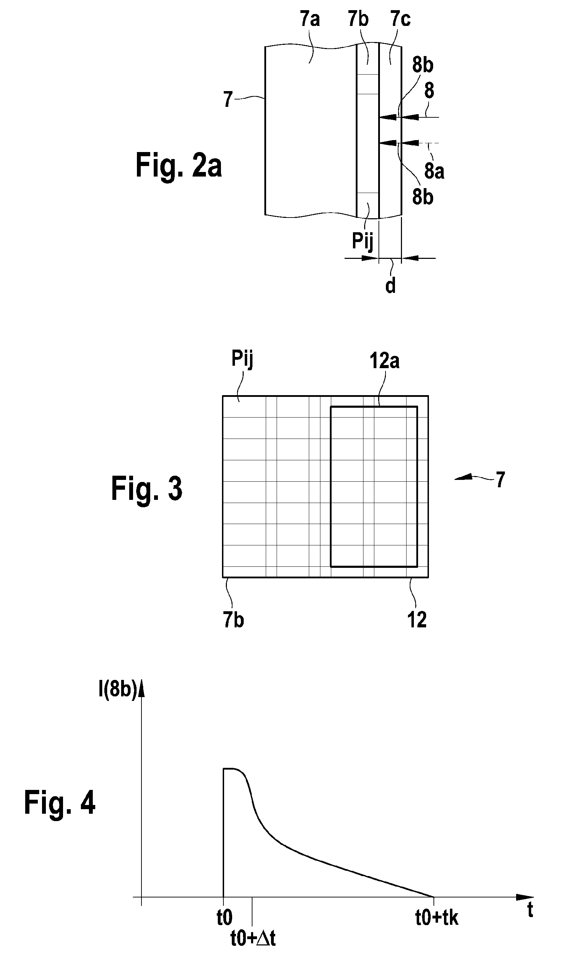

Die Kamera 3 weist in an sich bekannter Weise eine hier nicht detaillierter dargestellte Optik 6 und einen Imager-Sensor 7 auf, wobei in der schematischen Darstellung der Fig. 2 Aperturen usw. nicht detailliert eingezeichnet sind.

In dem Fahrzeugumfeld 4 sind unterschiedliche Objekte angeordnet, insbesondere nicht leuchtende Objekte 10 wie z.B. Bäume am Straßenrand, Verkehrsschilder, usw. Insbesondere bei einer Nachtfahrt werden auch beleuchtete Verkehrsteilnehmer erfasst, die mindestens eine Lichtquelle 14 mit kontinuierlicher Beleuchtung oder eine Lichtquelle 11 mit gepulster Beleuchtung aufweisen. Die Lichtquellen 14 mit kontinuierlicher Beleuchtung sind insbesondere Frontscheinwerfer, aber auch z. B. Heckleuchten älterer Bauart; sie senden kontinuierliche Strahlung 8 aus. Als kontinuierlich wird hierbei Strahlung 8 bzw. Licht aufgefasst, die z. B. allenfalls im Bereich einiger zehntel Sekunden variiert, wie z. B. auch Blinklicht zur Anzeige von Abbiegevorgängen oder Warnblinklicht. Die Lichtquellen 11 mit gepulster Beleuchtung sind im allgemeinen mit LEDs aufgebaut und können insbesondere Rückleuchten und Bremsleuchten, weiterhin auch Frontscheinwerfer mit gepulster Beleuchtung sein; sie senden gepulste Strahlung 8a aus, die im Allgemeinen Pulsdauern von deutlich weniger als einer Zwanzigstelsekunde bzw. 50 msec aufweist. Dieser Wert orientiert sich am menschlichen Auge von etwa 20 fps. Die nicht selbsttätig leuchtenden Objekte 10 reflektieren sowohl kontinuierliche als auch gepulste Strahlung 8, 8a; sie können insbesondere von einem Scheinwerfer 15 des Fahrzeugs 1 beleuchtet werden, der im optischen Bereich und/oder im infraroten Bereich - insbesondere bei Nachtsichtsystemen - Strahlung aussendet, so dass die Objekte 10 somit selbst Lichtquellen 11 oder 14 darstellen.

Der Imager-Sensor 7 ist in CMOS- oder CCD-Prozesstechnik hergestellt, auf einem Schaltungsträger angeordnet und weist unter anderem ein Substrat 7a und eine fotosensitive Schicht 7b auf, die einfallende elektromagnetische Strahlung 8 in einem vorgegebenen Wellenlängenbereich im optischen und/oder infraroten Bereich in elektrische Signale umwandelt und mit einer Framerate bzw. Auslesefrequenz von z.B. 50 fps (Frames per second, Bilder pro Sekunde) ausgelesen wird. Die fotosensitive Schicht 7b ist hierbei in bekannter Weise gemäß Fig. 3 als Matrixanordnung aus Imager-Pixeln Pij ausgebildet, die das Bild winkelaufgelöst aufnehmen und sukzessive, zeilen- und spaltenweisen zur Bildung eines Frames ausgelesen werden, woraufhin die als Framesignale fi an eine nachfolgende Steuereinrichtung 9 ausgegeben werden.

Erfindungsgemäß ist auf der fotosensitiven Schicht 7b eine phosphoreszierende Schicht 7c aufgetragen. Die phosphoreszierende Schicht 7c weist einen nachleuchtenden Effekt in einem bestimmten Wellenlängenbereich λp auf. Bei Eintreffen von optischer oder infraroter Strahlung dieses Wellenlängenbereichs als Primärlicht werden in der phosphoreszierenden Schicht 7c Teilchen derartig angeregt, das sie auch bei Abwesenheit des Primärlichtes noch eine gewissen Zeit lang nachleuchten und somit wie in Fig. 2a eingezeichnet zeitlich verzögert Nachleuchtlicht 8b bzw. Nachleuchtstrahlung der gleichen Wellenlänge ausgegeben wird. Die Zeitkonstante tk des Nachleuchteffektes beträgt bei der oben genannten Framerate von 50 fps des Imager-Sensors 7 bzw. dessen sensitiver Schicht 7b z.B. tk = 40 ms. Somit wird selbst sehr kurzzeitig auftretende, gepulste Strahlung 8a mit kurzer Pulsdauer aufgrund der Zeitkonstante tk in der Nachleuchtschicht 7c zu einem Nachleuchten führen, das beim Auslesen in mindestens einem Frame erkannt wird. Hierbei wird ein Teil der auftreffenden Strahlung 8 oder 8a transmittiert und ein weiterer Teil absorbiert und verzögert abgegeben.

Fig. 4 zeigt die Intensität I(8b) der von der passiven Nachleuchtschicht 7c an die fotosensitive Schicht 7b abgegebenen Strahlung 8b in Abhängigkeit der Zeit t. Ein zum Zeitpunkt t0 bzw. einem ersten, kurzen Zeitintervall (t0, t0+Δ) auftreffender Peak der Strahlung 8a wird teilweise transmittiert, wodurch sich bei t0 ein entsprechender Peak ergibt, und teilweise in einem großen Zeitintervall zwischen t0 und t0+tk abgegeben. Hierbei kann auch über t0+tk hinaus Strahlung abgegeben werden, so dass tk z. B. auch eine Zeitkonstante für einen exponentiellen Abfall der Form exp(-(t-t0)/tk) sein kann. Somit ergibt sich die erfindungsgemäße optische zeitliche Tiefpassfilterung aus der in Fig. 4 gezeigten Nachleuchtwirkung bei einfallender gepulster Strahlung 8a.

Gemäß Fig. 3 kann die Nachleuchtschicht 7c auf einen Teilbereich 12a der Vorderseite 12 beschränkt sein. Die Auswahl des Teilbereichs 12a berücksichtigt die Anordnung möglicherweise relevanter gepulster Lichtquellen 11 in dem von der Kamera 3 erfassten Fahrzeugumfeld 4; hierbei kann der Teilbereich 12a insbesondere einem sich direkt vor dem Fahrzeug 1 erstreckenden Fahrbahnbereich 5 entsprechen. Hierzu kann z.B. angenommen werden, dass bei Rechtsverkehr die rechte Straßenhälfte Rückleuchten von vor dem Fahrzeug 1 fahrenden anderen Fahrzeugen erfassen kann. Neben dem Fahrzeug 1, gegebenenfalls auch im linken Fahrbahnbereich vor dem Fahrzeug 1, ist der Empfang von gepulstem Licht 8a zumindest relativ unwahrscheinlich. Die Anordnung des Teilbereichs 12a berücksichtigt hierbei den Strahlengang aufgrund der Optik 6 bzw. die Position der Abbildung auf dem Imager-Sensor 7 gegenüber dem realen Bild. Somit kann z.B. der Teilbereich 12a im Wesentlichen in einer linken Fläche der Vorderseite 12 des Imager-Sensors 7 ausgebildet sein, um bei invertierender Optik für Objekte im rechten Bereich des vorderen Fahrzeugumfeldes 4 einen Nachleuchteffekt zu bewirken.

Die Nachleuchtschicht 7c ist vorteilhafterweise in einem vorgegebenen Wellenlängenbereich λn, z.B. um eine Wellenlänge λ =630 nm herum, in oben beschriebener Weise nachleuchtend, d.h. sie absorbiert einen Teil der einfallenden Strahlung und gibt ihn zeitlich verzögert wieder als Nachleuchtstrahlung 8b aus. In weiteren Wellenlängenbereichen ist die Nachleuchtschicht 7c vorteilhafterweise transparent, so dass diese Wellenlängenbereiche der Strahlung 8, 8a durch die Nachleuchtschicht 7c nicht beeinflusst werden. Der relevante Wellenlängenbereich λn kann z.B. von 400 nm bis in den Infrarotbereich von z. B. 1000 nm reichen, damit auch ein Scheinwerfer 15 für eine Nachtsichtfunktion (Night Vision), der gepulste infrarote Strahlung 8 oder 8a aussendet, erfasst wird.

Die Tiefpasswirkung der Nachleuchtschicht 7c führt bei gepulstem Licht 8a dazu, dass die durch die Nachleuchtschicht 7c tretende Strahlung 8b im Mittel die gleiche Intensität wie die gepulste Strahlung 8a aufweist (wobei eventuell ein geringer Verlust durch Strahlungsabsorption möglich ist) und somit die Imager-Pixel Pij in der sensitiven Schicht 7b beim Abtasten eine niedrigere Intensität anzeigen, als es bei Sensierung der gepulsten Strahlung 8a während deren Pulsdauer ergeben würde. Somit führt die Nachleuchtschicht 7c dazu, dass zum einen immer ein Signal bzw. eine Beleuchtung der Imager-Pixel Pij erkannt wird und zum anderen eine gemittelte Intensität angezeigt wird. Die nicht gepulste Strahlung 8 wird von dieser zeitlichen Mittelung bzw. nicht bzw. kaum beeinflusst. Auch wird die Dynamik in der Aufnahme und Darstellung bei einer Zeitkonstante von z.B. tk=40 ms für den Fahrer nicht erkennbar und somit vernachlässigbar verändert.

Die Steuereinrichtung 9 kann insbesondere auch eine Fernlicht-Assistenz-Funktion ansteuern, so dass der Frontscheinwerfer 15 über Signale S1 angesteuert werden kann und bei Erkennen eines anderen Verkehrsteilnehmers von Fernlicht auf Abblendlicht umgeschaltet wird. Weiterhin kann die Steuereinrichtung 9 auch ein Bild auf einem Monitor 17 im Fahrzeug 1 ausgeben.

Grundsätzlich kann die Nachleuchtschicht 7c auch mit meiner komplexeren Strukturierung ausgebildet sein. Hierbei kann die Dicke d der sensitiven Schicht 7b in lateraler Richtung variiert sein, so dass in dem als relevant erkannten Teilbereich 12a eine größere Dicke d und somit ein stärkerer Nachleuchteffekt, d.h. eine stärkere Absorption durch die Nachleuchtschicht 7c und schwächere Transmission, eingestellt sein als in anderen Bereichen, bei denen jedoch noch eine schwächere Nachleuchtwirkung eingestellt ist. Somit kann auch in diesem weiteren Teilbereichen, bei denen die Aufnahme von gepulsten Licht als nicht wahrscheinlich erkannt ist, grundsätzlich ein gepulstes Licht als schwaches Signal sicher erkannt werden. Weiterhin kann auch die Zeitkonstante tk in der in Fig. 3 gezeigten lateralen Richtung, d.h. in der Bildebene bzw. der Ebene der Oberfläche 12 des Imager-Sensors 7, variiert werden.

Die Nachleuchtschicht 7c kann z.B. aus einem Sulfid oder Sulfiden von Erdalkalimetallen und Zink unter Beimischung von Schwermetallsalzen hergestellt sein, z.B. als Zinksulfid mit Spuren eines Schwermetalls, z.B. eines Bleisalzes.

Die Nachleuchtschicht 7c kann grundsätzlich aktiv oder passiv sein. Eine passive Schicht kann insbesondere durch entsprechende phosphoreszierende Beschichtungen der oben genannten Art ausgebildet sein. Weiterhin kann auch eine aktive Nachleuchtschicht vorgesehen sein, die mit zusätzlicher Energie versorgt wird und bei Empfang der Strahlung 8 oder 8a durch die zusätzlich aufgenommene Energie ein stärkeres Nachleuchten bewirkt, z. B. als Photomultiplier bzw. Sekundärelektronenvervielfacher. Als Energie kann insbesondere eine elektrische Spannung angelegt sein oder gegebenenfalls auch zusätzliche Strahlung verwendet werden.

Erfindungsgemäß können auf der Nachleuchtschicht 7c eine oder mehrere weiteren Schichten vorgesehen sein, insbesondere eine Antireflexschicht, und/oder gegebenenfalls auch eine Schicht zur Ausbildung eines halbdurchlässigen Spiegels, um die von der Nachleuchtschicht 7c zurückgesandte Strahlung, die somit nicht im Strahlengang nach hinten weiter zur sensitiven Schicht 7b gelangt, wieder zurück zu spiegeln.

## Patentansprüche

1. Kamera zur winkelaufgelösten Erfassung eines Fahrzeugumfeldes (4), die einen Imager-Sensor (7) aufweist, der mindestens eine fotosensitive Schicht (7a) mit mehreren Bildpixeln (Pij) zur winkelaufgelösten Aufnahme von sichtbarer optischer und/oder infraroter Strahlung (8, 8a, 8b) und zur Ausgabe eines Bildsignals (fi) aufweist,
**dadurch gekennzeichnet, dass**
auf oder vor dem Imager-Sensor (7) eine nachleuchtende Einrichtung (7c) vorgesehen ist, die zumindest einen Teil der aufgenommenen Strahlung (8, 8a) mit einer zeitlichen Tiefpassfilterung zu der fotosensitiven Schicht (7a) weitergibt.

2. Kamera nach Anspruch 1, **dadurch gekennzeichnet, dass** der Imager-Sensor (7) in CMOS- oder CCD-Technolgie ausgebildet ist.

3. Kamera nach Anspruch 1 oder 2, **dadurch gekennzeichnet, dass** die nachleuchtende Einrichtung als Nachleuchtschicht (7c) auf der Vorderseite (12) des Imager-Sensors (7) aufgetragen ist, vorzugsweise direkt auf der fotosensitiven Schicht (7b) des Imager-Sensors (7).

4. Kamera nach einem der vorherigen Ansprüche, **dadurch gekennzeichnet, dass** die von der nachleuchtenden Einrichtung (7c) aufgenommene Strahlung (8, 8a) mit der zeitlichen Verzögerung (tk) mit gleicher Wellenlänge wieder als verzögerte Strahlung (8b) ausgegeben wird.

5. Kamera nach einem der vorherigen Ansprüche, **dadurch gekennzeichnet, dass** die Framerate (fr) des Auslesens eines Frames oder Bildes der Kamera (3) mindestens das Doppelte des Kehrwertes einer Zeitkonstante (tk) der nachleuchtenden Einrichtung (7) darstellt.

6. Kamera nach einem der vorherigen Ansprüche, **dadurch gekennzeichnet, dass** die Framerate (fr) des Auslesens eines Frames oder Bildes der Kamera (3) im Wesentlichen das Doppelte des Kehrwertes einer Zeitkonstante (tk) der nachleuchtenden Einrichtung (7) darstellt.

7. Kamera nach einem der vorherigen Ansprüche, **dadurch gekennzeichnet, dass** die nachleuchtende Einrichtung (7c) ein phosphoreszierendes Material aufweist.

8. Kamera nach einem der vorherigen Ansprüche, **dadurch gekennzeichnet, dass** die nachleuchtende Einrichtung (7c) aktiv nachleuchtend ist und Energie zum zeitlich verzögerten Aussenden von Strahlung aufnimmt.

9. Kamera nach einem der vorherigen Ansprüche, **dadurch gekennzeichnet, dass** die nachleuchtende Einrichtung (7c) in der Ebene der Vorderseite (12) des Imager-Sensors (7) lateral strukturiert ist.

10. Kamera nach Anspruch 9, **dadurch gekennzeichnet, dass** die nachleuchtende Einrichtung (7c) einen Teilbereich (12a) der Vorderseite (12) des Imager-Sensors (7) bedeckt.

11. Kamera nach Anspruch 9 oder 10, **dadurch gekennzeichnet, dass** die Nachleuchtwirkung, insbesondere die Dicke (d) der nachleuchtenden Einrichtung (7c), in lateraler Richtung strukturiert ist.

12. Kamera nach einem der Ansprüche 9 bis 11, **dadurch gekennzeichnet, dass** ein Teilbereich (12a) der nachleuchtenden Einrichtung (7c), der einen Fahrbahnbereich vor dem Fahrzeug (1) aufnimmt, mit stärker Nachleuchtwirkung ausgebildet ist.

13. Kamera nach einem der vorherigen Ansprüche, **dadurch gekennzeichnet, dass** die Nachleuchtschicht (7c) in einem relevanten Wellenlängenbereich (λn), insbesondere zwischen 600 und 660 nm, eine hohe Nachleuchtwirkung aufweist und außerhalb des relevanten Wellenlängenbereichs im Wesentlichen transparent ist.

14. Fahrzeug (1) mit einer Kamera (3) nach einem der vorherigen Ansprüche und einer Steuereinrichtung (9) zum Aufnehmen der Bildsignale (fi) der Kamera (3), wobei die Steuereinrichtung (9) eine Fernlicht-Assistenz-Funktion zum Umschalten zwischen Fernlicht und Abblendlicht eines Scheinwerfers (15) des Fahrzeuges (1) ansteuert.
